Europäisches Patentamt

European Patent Office

Office européen des brevets

(11) Numéro de publication: **0 318 379**
**A1**

# DEMANDE DE BREVET EUROPEEN

(21) Numéro de dépôt: **88402949.7**

(22) Date de dépôt: **24.11.88**

(51) Int. Cl.4: **H 03 F 3/193**

(30) Priorité: **27.11.87 FR 8716466**

(43) Date de publication de la demande:
**31.05.89 Bulletin 89/22**

(84) Etats contractants désignés: **DE GB IT NL**

(71) Demandeur: **THOMSON HYBRIDES ET MICROONDES**
**173, bld Haussmann**
**F-75008 Paris (FR)**

(72) Inventeur: **Pham, Ngu Tung**
**THOMSON-CSF SCPI 19, avenue de Messine**
**F-75008 Paris (FR)**

(74) Mandataire: **Taboureau, James et al**
**THOMSON-CSF SCPI**
**F-92045 PARIS LA DEFENSE CEDEX 67 (FR)**

(54) **Amplificateur linéaire hyperfréquence à très large bande passante.**

(57) Un amplificateur linéaire hyperfréquence est décrit : sa bande passante est égale à celle des transistors qui le constituent, sans être limitée par les circuits de polarisation habituels qui comportent des selfs et des capacités à faible bande passante.

Dans cet amplificateur qui comporte au moins un transistor d'entrée (1), la polarisation de grille, au repos, est assurée par un circuit de type BFL (7,8,9,10,12), généralement utilisé en logique , dont la sortie est rebouclée sur l'entrée. Le signal d'entrée ($V_I$) est appliqué à la fois sur le transistor inverseur (7) du BFL et sur le transistor d'entrée (1). Le même circuit BFL utilisé dans un étage d'amplification (1 + 13) assure l'auto-adaptation des étages cascadables.

Application en linéaire, dans une bande de fréquence de 1 à 100 GHz, et à la régénération de signaux logiques.

FIG.2

EP 0 318 379 A1

## Description

## AMPLIFICATEUR LINEAIRE HYPERFREQUENCE A TRES LARGE BANDE PASSANTE

La présente invention concerne un amplificateur hyperfréquence, fonctionnant tant en linéaire qu'en logique, dont les circuits d'adaptation sont modifiés par rapport aux amplificateurs classiques pour lui permettre d'avoir une bande passante très large, comprise entre 1 et 100 Gigahertz. Dans cet amplificateur, les grilles des transistors des étages d'amplification sont polarisées à des tensions stables, fournies par des circuits ne comportant exclusivement que des transistors et des diodes, à l'exclusion des circuits comportant des resistances, selfs et capacités qui sont d'usage courant dans l'art connu. L'amplificateur selon l'invention est d'un type mixte linéaire et logique, car sa partie d'amplification linéaire est polarisée par des montages que l'on a l'habitude d'utiliser en logique.

L'invention s'applique essentiellement aux circuits hyperfréquence réalisés en arséniure de gallium ou de façon plus générale en matériau rapide de la famille III -V. On sait que les circuits logiques en GaAs peuvent fonctionner à des fréquences variant de quelques Mhz jusqu'à plusieurs dizaines de Ghz. En anneau, les inverseurs logiques peuvent avoir des temps de propagation minima d'une dizaine de picosecondes, ce qui montre que les circuits logiques ont une bande passante très large couvrant toutes les fréquences juqu'à 100 Ghz. La raison pour laquelle un circuit logique possède une bande passante très large vient de ce que les éléments de charge et de polarisation, pour que les niveaux logiques soient compatibles entre eux, sont réalisés à partir de composants semiconducteurs tels que les diodes et les transistors, qui possèdent eux mêmes une bande passante très large.

On sait par ailleurs qu'un transistor hyperfréquence peut amplifier,dans les circuits linéaires, jusqu'à des fréquences très élevées, mais les problèmes des amplificateurs hyperfréquences viennent des circuits d'adaptation, c'est à dire de polarisation et de charge, qui ont des bandes passantes assez étroites. En effet les circuits de polarisation, par exemple, sont généralement réalisés, à partir d'une tension de polarisation, au moyen de résistances, de selfs et de capacités qui ont elles-mêmes des bandes passantes assez étroites.

L'invention consiste donc à mettre en oeuvre des circuits connus en logique pour adapter et polariser les étages amplificateurs, de façon à obtenir un amplificateur linéaire de très large bande passante.

Pour fonctionner dans de bonnes conditions, un transistor hyperfréquence - très généralement de type à effet de champ - doit avoir sa grille polarisée au repos à une tension de polarisation correctement choisie selon les diagrammes de caractéristiques I(V) de transistor, mais cette tension de polarisation doit être stable. Il est classique de fournir la tension de polarisation à partir d'une source qui débite à travers une résistance en série avec une self, une capacité étant montée en parallèle et mise à la masse : ces composants consomment une grande surface en intégration monolithique, ce qui fait qu'ils ne sont pas désirés pour la fabrication de circuit intégré hyperfréquence en GaAs, mais ils ont en outre une bande passante étroite qui limite celle de l'amplificateur.

Selon l'invention, la grille d'au moins un transistor à effet de champ dans un amplificateur hyperfréquence est polarisée au repos par un circuit connu en logique qui comprend un inverseur de type BFL(Buffered fet logic), suivi par un décaleur. Le signal d'entrée est appliqué simultanément sur la grille du transistor à effet de champ d'entrée de l'inverseur et sur la grille du transistor à effet de champ d'entrée de l'amplificateur, lui-même connecté à la sortie du décaleur : chaque fois que la tension de polarisation sur la grille du transistor amplificateur varie, la réaction de la porte BFL et du décaleur ramène cette tension à sa valeur initiale.

Par ailleurs, l'amplificateur comporte au moins un étage dans lequel deux transitors sont montés en amplificateur différentiel, à la façon d'une porte logique OU-NON. La grille du premier transistor reçoit le signal d'entrée. La grille du second transistor est polarisée par le signal de sortie de cet étage, à travers un circuit comprenant un inverseur et un décaleur identiques au circuit décrit ci-dessus : ce montage permet de stabiliser la tension de polarisation du second transistor de cet étage et en même temps la tension de polarisation du transistor d'entrée d'un étage d'amplification suivant. Plusieurs étages d'amplification peuvent alors être montés en cascade, puisque leurs entrées et leurs sorties sont autoadaptées.

De façon plus précise l'invention concerne un amplificateur linéaire hyperfréquence à très large bande passante, comportant au moins un transistor à effet de champ dont la grille reçoit un signal d'entrée, cet amplificateur étant caractérisé en ce que le circuit de polarisation au repos de la grille de ce transistor d'entrée est constitué par un circuit logique de type BFL comportant :
- un inverseur formé par un transistor et sa charge active, alimentée à partir d'une première source de tension
- un décaleur formé par un transistor dont la grille est réunie au drain du transistor de l'inverseur, et dont la source est réunie à au moins une diode et à un transistor source de courant, le décaleur étant alimenté entre la première source de tension et une deuxième source de tension négative,
- le signal d'entrée étant appliqué simultanément sur la grille du transistor de l'inverseur, et sur la grille du transistor d'entrée de l'amplificateur, ladite grille étant en outre réunie au point de sortie du décaleur commun à la cathode de la diode et au drain du transistor source de courant.

L'invention sera mieux comprise par la description plus détaillée qui suit maintenant d'un exemple de réalisation d'amplificateur hyperfréquence de très large bande, cette description s'appuyant sur les figures jointes en annexe, qui représentent :
  - figure 1 : circuit de polarisation d'un transistor à effet de champ hyperfréquence selon l'art connu,
  - figure 2 : circuit de polarisation d'un transistor à effet de champ hyperfréquence selon l'invention,

2

- figure 3 : diagramme électrique d'un amplificateur hyperfréquence à très large bande passante selon l'invention.

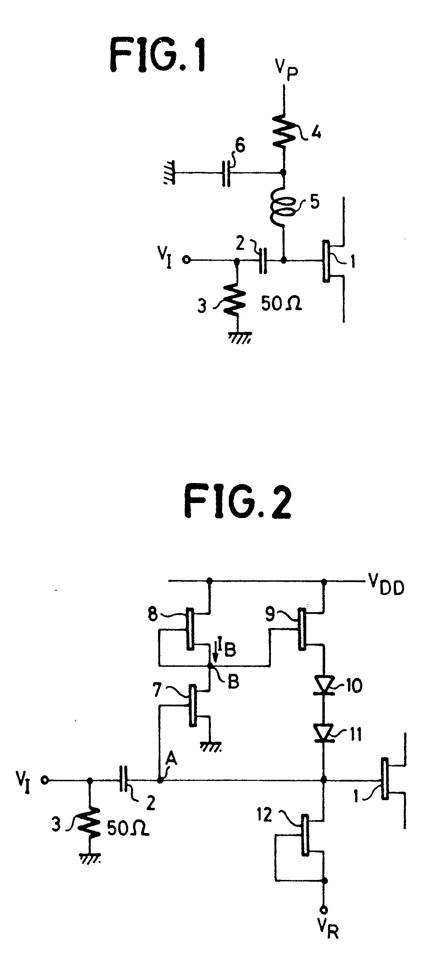

La figure 1, qui représente un circuit de polarisation d'un transistor à effet de champ hyperfréquence selon l'art connu, a pour objet de rappeler les limitations apportées par les techniques de l'art connu. Un transistor à effet de champ 1, qui est par exemple le transistor d'entrée d'un amplificateur, reçoit sur sa grille un signal d'entrée $V_I$ qui est souvent appliqué à travers une capacité de liaison 2, avec une impédance d'entrée 3 qui est très généralement normalisée à 50 Ohms. Pour que le transistor 1 fonctionne correctement il convient de polariser cette grille à une tension fixe fournie par une source de tension de polarisation $V_P$, mais cette tension est appliquée à travers un circuit tel que celui qui est représenté, ou à travers d'autres types de circuit qui utilisent des composants passifs, par opposition aux composants semiconducteurs. Dans le cas de la figure 1, qui n'est donc pas limitatif de l'art connu, la tension de polarisation VP est limitée à travers une résistance 4, montée en série avec une self 5, tandis qu'une capacité 6 assure le découplage à la masse. Le principal inconvénient de ce type de circuit de polarisation réside en ce que la self 5 et la capacité 6 occupent une place importante sur la pastille d'un circuit intégré, s'il s'agit d'un circuit hyperfréquence intégré sur un matériau rapide III-V, mais de toutes façons le circuit composé par une self 5 et une capacité 6 a lui-même une bande passante relativement étroite qui limite donc la bande passante de l'amplificateur polarisé à travers ce circuit de polarisation.

Le fondement de l'invention consiste donc à fournir une tension de polarisation au moyen d'un circuit qui n'utilise que des composants semiconducteurs, ayant eux-mêmes une bande passante aussi large que les composants semiconducteurs qui constituent l'amplificateur. Le circuit de polarisation selon l'invention est représenté en figure 2.

Si l'on considère que le transistor 1 est le transistor d'entrée d'un amplificateur hyperfréquence, il reçoit sur sa grille le signal d'entrée $V_I$ à travers une capacité 2, et sous une impédance généralement normalisée à 50 Ohms par la résistance 3, par conséquent dans les mêmes conditions que dans l'art connu. Mais la tension de polarisation appliquée sur sa grille, au repos, c'est à dire lorsqu'il n'y a pas de signal d'entrée, est obtenue au moyen d'un circuit comportant un inverseur de type BFL, suivi par un décaleur. La porte BFL est constituée par un transistor à effet de champ 7, chargé par un transistor de charge 8, lui-même alimenté à partir d'une tension $V_{DD}$. Le drain du transistor 7 est réuni à la source d'un transistor 8, elle même court-circuitée avec sa grille. La grille du transistor 7 est réunie en un point A au signal d'entrée de l'amplificateur. Au point B commun entre le drain du transistor 7 et la source du transistor 8, le signal inversé est appliqué sur la grille d'un transistor 9, dont le drain est lui aussi alimenté par la tension $V_{DD}$. La tension de la source du transistor 9 est décalée selon une technique par ailleurs connue à travers une ou deux diodes 10 et 11, bien que selon l'importance du décalage désiré il puisse y avoir un plus grand nombre de diodes. La cathode de la dernière des diodes de décalage est réunie à un transistor 12 dit de rappel, dont la source et la grille, court-circutées sont alimentées par une tension négative $V_R$.

Enfin le point commun entre la dernière des diodes de décalage et le drain du transistor de rappel 12, qui constitue la sortie de cet étage de décalage, est connectée sur la grille du transistor d'entrée 1 de l'étage amplificateur, mais en outre ce point est rebouclé sur le point A, où est connectée la grille du transistor d'entrée de la porte BFL.

Le transistor d'entrée 7 de l'étage inverseur a une transconductance $G_7$ ; le transistor charge active 8 fournit un courant $I_B$, et soit $V_A$ la tension au point A, et $V_T$ la tension de seuil du transistor 7. Chaque fois que la tension $V_A$ varie, le signal de variation est inversé par l'inverseur BFL 7 + 8, puis décalé à travers le transistor 9 monté en source suiveuse et à travers les diodes 10 et 11 : la réaction de l'étage décaleur ramène $V_A$ vers sa valeur initiale. En effet on peut observer que la tension au point commun entre la diode 11, la grille du transistor 1 et le drain du transistor 12 est la même que la tension en A. A l'équilibre, on a :

$$I_B = G_7 (V_A - V_T) \qquad (1)$$

Ce montage permet donc de polariser la grille du transitor d'entrée 1 de l'étage amplificateur à un niveau fixe et optimum choisi selon les courbes de caractéristiques de ce transistor 1.

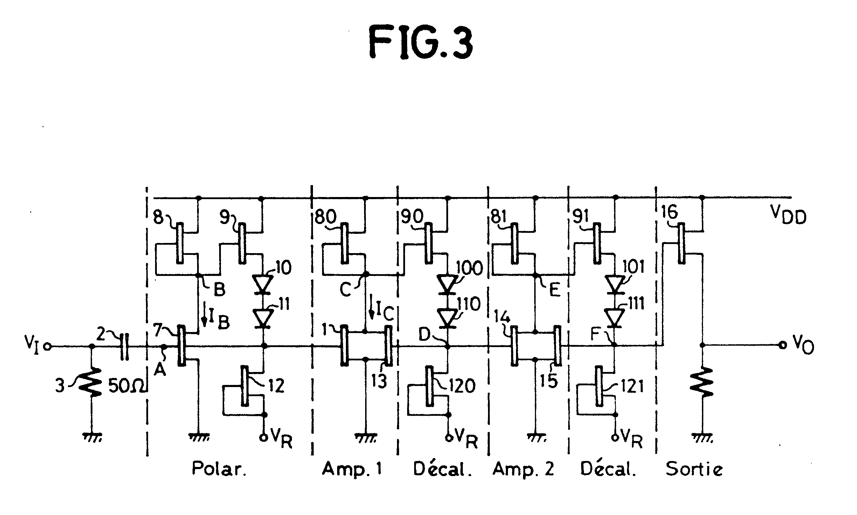

La figure 3 représente le schéma électrique d'un amplificateur à très large bande, utilisant le circuit de polarisation qui vient d'être décrit en figure 2, pour son étage d'entrée, ainsi que le même circuit pour assurer l'adaptation entre les étages de l'amplificateur. Sur cette figure ont été séparés par des traits pointillés verticaux l'étage de polarisation d'entrée, le premier étage d'amplification, le premier étage de décalage, un deuxième étage d'amplification et un deuxième étage de décalage, suivi par un étage de sortie. Considérons pour l'instant l'étage de polarisation et le premier étage d'amplification, avec son étage de décalage ou d'adaptation. Deux étages d'amplification ont été représentés sur cette figure 3 mais de façon plus générale l'amplificateur selon l'invention peut être cascadable et comporter un nombre quelconque d'étages d'amplification.

L'étage de polarisation est exactement identique, aux modifications de représentation graphique près, à l'étage de polarisation représenté en figure 2. Le transistor 7 de la porte BFL a été représenté de façon différente pour faciliter la constatation de la répétabilité du circuit entre l'étage de polarisation et les étages d'amplification.

Le premier étage d'amplification comporte un amplificateur différentiel constitué par le transistor 1, qui constitue donc le transistor d'entrée de l'amplificateur, et le transistor 13. Ces deux transitors sont montés en source commune et leurs drains réunis, ce qui donne une ressemblance avec une porte OU-NON à deux entrées en logique BFL. Le drain commun aux deux transistors 1 et 13 est réuni à une charge active 80, elle-même alimentée à partir d'une tension $V_{DD}$, comme d'ailleurs tous les transistors de l'amplificateur. La source de la charge 80, connectée à la grille, alimente la grille d'un transistor 90 monté en source suiveuse. Celui-ci débite à travers deux diodes de décalage 100 et 110, avec point commun entre la grille du transistor 13, la grille du transistor d'entrée 14 d'un étage d'amplification suivante, et le drain d'un transistor de rappel 120, connecté par sa source à une tension négative $V_R$. On peut observer que les indices de repère des composants de l'étage d'amplification et de l'étage de décalage ou d'adaptation à l'étage suivant ont été intentionnellement choisis pour mettre en évidence la similitude de circuit avec le circuit de polarisation. Dans cet étage d'amplification, l'inverseur BFL est constitué par les transistors 1 et 80 et l'étage de polarisation avec décalage est constitué par le transistor 90 et par les diodes 100 et 110 et le transistor de rappel 120. La différence entre l'étage de polarisation et ce premier étage d'amplification est qu'un transistor 13 est branché en parallèle avec le transistor 1, et qu'il a sa grille reliée au point commun D. Appelons C le point commun entre la source du transistor 80, le drain de l'amplificateur différentiel 11 + 13 et la grille du transistor suiveur 90. A l'équilibre on a

$I_C = I_1 + I_{13}$

si l'on appelle $I_1$ et $I_{13}$ les courants qui traversent les transistors 1 et 13.

$I_C = G_1 (V_A - V_T) + G_{13} (V_D - V_T)$     (2)

$G_1$ et $G_{13}$ étant les transconductances des transistors 1 et 13, les tensions de seuil $V_T$ étant les mêmes pour tous les transistors d'un même circuit intégré.

Cette équation 2 permet de fixer la tension d'équilibre $V_D$ au point D, c'est à dire la tension de polarisation à la fois du transistor 13 et du transistor 14 donc la tension de polarisation sur le transistor d'entrée de l'état suivant.

Par dérivation dans l'équation 2 on a :

$G_1 \Delta V_A + G_{13} \Delta V_D = 0$

puisque $I_C$ est une constante . On en tire

$$\Delta V_D = - \frac{G_1}{G_{13}} \Delta V_A = - A_1 \Delta V_A \qquad (3)$$

$$\text{avec } A_1 = \frac{G_1}{G_{13}}$$

qui constitue le facteur d'amplification. On peut noter donc que pour avoir amplification il faut que $G_1$ soit supérieur à $G_{13}$, mais on peut également avoir atténuation si on choisit $G_{13}$ plus grand que $G_1$.

L'équation 3 montre que chaque fois que la tension d'entrée $V_A$ varie de $\Delta V_A$, la tension de sortie $V_D$ du premier étage d'amplification est amplifiée en $- A_1 \Delta V_A$ : le circuit fonctionne bien comme un amplificateur linéaire.

Mais en outre puisque l'on a observé qu'une partie de cette étage d'amplification fonctionne exactement de la même façon que l'étage de polarisation d'entrée, on en conclut que la tension $V_D$ est stabilisée de la même façon que la tension de polarisation $V_A$ du transistor 1 : par conséquent la tension de polarisation du transistor d'entrée 14 d'un étage d'amplification suivant est elle aussi stabilisée. Il y a donc adaptation entre les étages cascadés dans un amplificateur à plusieurs étages.

Considérons maintenant un amplificateur qui comporterait deux étages d'amplification tel que représenté sur la figure 3. Le second étage d'amplification va fonctionner exactement de la même façon que le premier étage d'amplification et si l'on appelle E le point commun entre les drains de l'amplificateur différentiel, constitué par les transistors 14 et 15, et le transistor 81, et F le point commun entre les diodes décaleuses 101 et 111, le drain du transistor 121 et la grille du transistor 15, on a de la même façon que précédemment :

$I_E = I_{14} + I_{15}$

$I_E = G_{14} (V_D - V_T) + G_{15} (V_F - V_T)$     (4)

$G_{14}$ et $G_{15}$ étant les transconductances des transistors 14 et 15, $V_D$ la tension appliquée sur la grille du transistor d'entrée 14, $V_F$ la tension de sortie appliquée sur la grille du transistor 15, $V_T$ leur tension de seuil commune qui est la même pour tous les transistors du circuit integré. $V_D$ étant fixé par l'équation 2, l'équation 4 fixe la tension $V_F$.

De même façon que précedemment on obtient l'amplification en petit signaux :

$$\Delta V_F = - \frac{G_{14}}{G_{15}} \Delta V_D = - A_2 \Delta V_D$$

D'où $\quad V_F = A_1\, A_2\, \Delta V_A$

Les deux étages d'amplification donnent un gain en décibels qui est la somme des gains en décibels de chaque étage.

Les signaux de sortie au point F du second étage peuvent être amplifiés par un dernier étage de puissance constitué par un transistor 16, qui permet de sortir des signaux utilisables dans des liaisons à 50 Ohms par exemple.

L'amplificateur décrit comporte donc des sections qui sont de type linéaire tels que les amplificateurs différentiels des deux étages, ainsi que des sections dont le schéma est en soi connu mais qu'on a l'habitude d'utiliser dans les circuits de type logique. Cette alliance entre circuit logique et circuit linéaire permet d'adapter des étages les uns aux autres et de maintenir les transistors amplificateurs à leur point de polarisation préféré.

Cet amplificateur peut être utilisé dans les circuits hyperfréquence de large bande, mais il est en outre un excellent amplificateur de signaux logiques. Dans les transmissions numériques par exemple les signaux sont affaiblis après avoir parcouru une grande distance : pour régénérer les signaux logiques on peut préférablement les amplifier au moyen de l'amplificateur selon l'invention, en ligne, et on obtient des signaux logiques amplifiés et remis en forme grâce à l'amplification.

## Revendications

1 - Amplificateur linéaire hyperfréquence à très large bande passante, comportant au moins un transistor à effet de champ (1) dont la grille reçoit un signal d'entrée ($V_I$), cet amplificateur étant caractérisé en ce que le circuit de polarisation au repos de la grille de son transistor d'entrée (1) est constitué par un circuit logique de type BFL comportant :
- un inverserseur formé par un transistor (7) et sa charge active (8), alimentée à partir d'une première source de tension ($V_{DD}$)
- un décaleur formé par un transistor (8) dont la grille est réunie au drain du transistor (7) de l'inverseur, et dont la soruce est réunie à au moins une diode (10) et à un transistor (12) source de courant, le décaleur étant alimenté entre la première source de tension ($V_{DD}$) et une deuxième source de tension négative ($V_2$),
- le signal d'entrée ($V_I$) étant appliqué simultanément sur la grille du transistor (7) de l'inverseur, et sur la grille du transistor (1) d'entrée de l'amplificateur, ladite grille étant en outre réunie au point de sorte du décaleur, commun à la cathode de la diode (10) et au drain du transistor source de courant (12).

2 - Amplificateur linéaire hyperfréquence selon la revendication 1 comportant au moins un étage d'amplification dont le transistor d'entrée (1) a sa grille polarisée au repos par un circuit logique de type BFL, cet amplificateur étant caractérisé en ce que son étage d'amplification comporte :
- un amplificateur différentiel formé par ledit transistor d'entrée (1) et par un second transistor (13), leurs sources étant réunies à la masse, et leurs drains réunis ensemble,
- un circuit d'autoadaptation de type BFL pour lequel le transistor d'entrée (1) de l'étage constitue également le transistor d'entrée de l'inverseur (1 + 80), la sortie (D) du décaleur (90 + 100 + 120) de ce circuit BFL étant réunie à la grille du second transistor (13) de l'amplificateur différentiel et à une charge (14) , dont la tension de polarisation au repos est ainsi autoadaptée, et suit la tension de polarisation de grille du transistor d'entrée (1).

3 - Amplificateur linéaire hyperfréquence selon la revendication 1, caractérisé en ce que la tension de polarisation au repos ($V_A$) de la grille du transistor d'entrée (1) est définie par l'équation
$$I_B = G_7\,(V_A - V_T)$$
$I_B$ étant le courant qui traverse le transistor inverseur (7) de transconductance $G_7$,
$V_T$ étant la tension de seuil commune à tous les transistors du circuit.

4 - Amplificateur linéaire hyperfréquence selon la revendication 1, caractérisé en ce que le décaleur (9 + 10 + 12) dans le circuit de type BFL stabilise la tension de polarisation au repos ($V_A$) de la grille du transistor d'entrée (1) à son équilibre.

5 - Amplificateur linéaire hyperfréquence selon la revendication 2, caractérisé en ce que la tension de polarisation au repos ($V_D$) de la grille du second transistor (13) de l'amplificateur différentiel (1 + 13) est autoadaptée en fonction de la tension de polarisation au repos ($V_A$) de la grille du transistor d'entrée (1) selon l'équation :

$$\Delta V_D = -\frac{G_1}{G_{13}}\,\Delta V_A = -A_1\,\Delta V_A$$

dans laquelle

$G_1$ est la transconductance du transistor d'entrée (1)

$G_{13}$ est la transconductance du second transitor (13) de l'amplificateur différentiel (1 + 13)

$A_1 = G_1/G_{13}$ est le facteur d'amplification.

6 - Amplificateur linéaire hyperfréquence selon la revendication 2, caractérisé en ce que plusieurs étages d'amplification sont cascadables, les tensions de polarisation au repos ($V_A$, $V_D$, $V_F$) étant autoadaptées.

7 - Amplificateur linéaire hyperfréquence selon l'une quelconque des revendications précédentes, caractérisé en ce que la bande passante de ses circuits de polarisation (7 + 8 + 9 + 10 + 12) et d'autoadaptation (80 + 90 + 100 + 120) est la même que celle des circuits d'amplification (1 + 13), tous les transistors de cet amplificateur étant réalisés dans la même technologie.

8 - Amplificateur linéaire hyperfréquence selon l'une quelconque des revendications précédentes, caractérisé en ce qu'il est réalisé en circuit intégré, sur matériau rapide de la famille III - V tel que GaAs.

# FIG.1

# FIG.2

# FIG.3

EP 0 318 379 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | IEEE JOURNAL OF SOLID-STATE CIRCUITS, vol. SC-17, no. 6, décembre 1982, pages 1166-1173, IEEE, New York, US; D.B. ESTREICH: "A monolithic wide-band GaAs IC amplifier" <br> * Figures 5,6; pages 1168,1169, paragrahe B: "Intermediate stage design" * | 1-4,8 | H 03 F 3/193 |
| A | IEEE TRANSACTIONS ON MICROWAVE THEORY AND TECHNIQUES, vol. MTT-33, no. 8, août 1985, pages 686-692, IEEE, New York, US; Y. IMAI et al.: "Design and performance of monolithic GaAs direct-coupled preamplifiers and main amplifiers" <br> * Figures 6,10; paragraphes III.A, III.B * | 1-4,6,8 | |
| A | DE-A-2 846 687 (SIEMENS AG) <br> * Figures 1-3; pages 3-6 * | 1-4 | |

**DOMAINES TECHNIQUES RECHERCHES (Int. Cl.4)**

H 03 F

Le présent rapport a été établi pour toutes les revendications

| Lieu de la recherche | Date d'achèvement de la recherche | Examinateur |
|---|---|---|
| LA HAYE | 28-02-1989 | TYBERGHIEN G.M.P. |